# EUROPEAN PATENT APPLICATION

(11) **EP 0 562 791 A1**
(43) Date of publication of application: **29.09.1993**
(21) Application number: 93302137.0
(22) Date of filing: 22.03.1993
(51) Int. Cl.: G01R 33/38

(54) **Gradient amplifier system employing a combination of linear amplifiers and DC power sources**

(30) Priority: 23.03.1992 US 854736
(71) Applicant: GENERAL ELECTRIC COMPANY, Schenectady, NY 12345 (US)
(72) Inventor: McFarland, Thomas George, Hartland, Wisconsin 53029 (US); Vavrek, Robert Michael, Waukesha, Wisconsin 53188 (US); Wirth, William Frederick, Sullivan, Wisconsin 53178 (US)
(74) Representative: Lupton, Frederick

(57) **Abstract**

A gradient amplifier for use in magnetic resonance imaging equipment employs linear amplifiers in tandem with DC power supplies, the latter serving to provide increased power for rapid gradient switching and the former providing correction current to produce the desired continuous output. The DC power supplies are controlled open loop from the gradient signal used to designate the current in the gradient coil and the amplifiers are operated closed loop in response to a feedback signal from the gradient coil. The DC power supplies may comprise multiple DC units which may be combined to provide finer steps of control prior to correction by the linear amplifier. The units may be weighed in binary fashion to provide improved resolution. The DC power supply in a second embodiment may include storage capacitors that have their charge maintained by the amplifiers receiving a correction current derived from the peak charge on the capacitors.

## Description

### Background of the Invention

This invention relates to magnetic resonance imaging apparatus and more specifically to high current, gradient amplifier systems for use in such apparatus.

Magnetic resonance imaging ("MRI") has developed as an important tool in diagnostic medicine. In MRI, as is understood by those skilled in the art, a body being imaged is held within a uniform magnetic field oriented along a z-axis of a Cartesian coordinate system.

The spins of the nuclei of the body are excited into precession about the z-axis by means of a radio frequency (RF) pulse. The decaying precession of these excited spins produces an NMR signal whose amplitude is dependant, among other factors, on the number of precessing nuclei per volume within the imaged body. This number of spins is termed the "spin density".

An image of the spin density, or other characteristics revealed by the NMR signal, my be produced by impressing precisely controlled magnetic gradient fields Gₓ, G_{y}, and G_{z} along the x, y and z axes. These gradient fields, created by gradient coils driven by a gradient amplifier system, encode position information into the NMR signals through phase and frequency shifting of the NMR signal for spins in different locations.

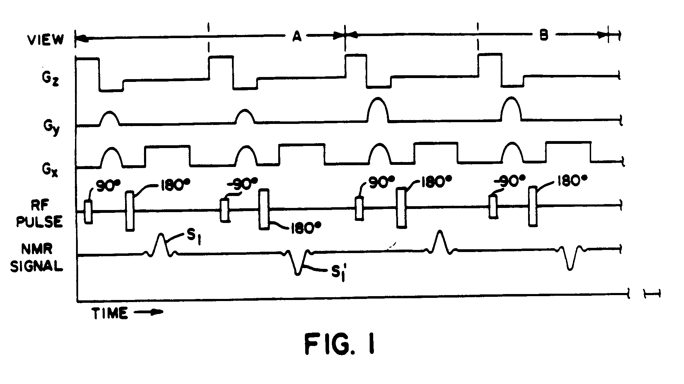

Referring to Fig. 1, a typical "spin echo" pulse sequence for acquiring data under the spin warp MRI technique includes: 1) a z-axis gradient G_{z} activated during a first 90° RF pulse to select the image slice in the z-axis, 2) a y-axis gradient field G_{y} to phase encode the precessing nuclear spins in the y direction, and 3) an x-axis gradient Gₓ activated during the acquisition of the NMR signal to frequency encode the precessing nuclear spins in the x direction. Two such NMR acquisitions, S₁ and S₁', the latter inverted and summed with the first, comprise the NMR signal of a single view "A" under this sequence. Note that the y gradient field G_{y} changes between view "A" and subsequent view "B". This pulse sequence is described in detail in U.S. Patent No. 4,443,760, entitled: "Use of Phase Alternated RF Pulses to Eliminate Effects of Spurious Free Induction Decay Caused by Imperfect 180 Degree RF Pulses in NMR Imaging", and issued April 17, 1984, assigned to the same assignee as the present invention and incorporated by reference.

A set of NMR signals comprised of many views may be "reconstructed" to produce an image of a single slice of an imaged object according to well understood techniques. Multiple slices are needed to generate information over three dimensions of the imaged object.

The speed with rich slice images may be obtained is limited, to a large extent, by the speed with which the gradient fields may be changed. The gradient coils are substantially inductive loads and hence obtaining higher speed switching of the gradient fields requires amplifiers capable of producing correspondingly higher voltages. These higher voltages, together with the high currents required by the gradient coils (of 200 Amperes or more), demand amplifiers capable of extremely high power output.

The gradient amplifiers must also be capable of accurate control of the gradient current delivered to the gradient coils and should allow the maximum possible flexibility in the generation of gradient waveforms of arbitrary shape for present and future imaging techniques. For this reason, high powered linear amplifiers are most commonly used.

Present linear amplifiers use as many as eighty power transistors for each gradient to produce adequate power to drive the gradient coils. Increasing the power output from such amplifiers by increasing the number of such power transistors may unacceptably increase the cost and complexity of the amplifiers and decreases their reliability.

### Summary of the Invention

This invention relates to a gradient amplifier system in which DC power supplies are connected in tandem with conventional linear gradient amplifiers to boost the effective gradient power to the gradient coils.

Aspects of the invention are set forth in claims 1 and 8.

Specifically, a DC power supply receiving a gradient signal has an output connected to the gradient coil for generating a first voltage component, selectable from a discontinuous range of output voltages, and approximating a desired magnetic gradient field. A feedback sensor is connected to the gradient coil for producing a feedback signal which is used to control an amplifier. The amplifier has an output also connected to the gradient coil for generating in the gradient coil a second voltage component, but within a continuous range of output voltages. The feedback signal and the gradient signal are used by the amplifier to adjust the second voltage component so that the sum of the first and second voltage components provides the desired magnetic gradient field.

It is thus one object of the invention to obtain the power efficiency and simplicity of using a DC source to drive a gradient coil, while still maintaining the ability to precisely generate arbitrary waveforms. DC power supplies may employ relatively simple construction or may operate with extremely low power dissipation. The amplifier serves to "fill in" the stepped output of the DC power supply to provide effective linear control. The correction provided by the amplifier permits the DC power supplies to have relatively little internal regulation. In fact, the DC power supplies may be no more than charged capacitors, provided the amplifier has the range to compensate for their varying output.

It is another object of the invention to take advantage of the intermittent power demands of gradient coils. The DC power supplies provide power for peak demand and may accumulate energy in storage capacitors or the like, at other times to thus require lower powered components.

In one embodiment, the DC power supply may be constructed of multiple DC sources, each source providing an incremental voltage to the gradient coils together to offer several output voltage levels. The values of the voltages from each DC source may stand in binary relationship with the voltages of the other sources. The gradient current is, in either case, generated by switching the appropriate combination of DC sources together.

It is thus another object of the invention to provide a plurality of DC sources that may, together, better approximate the voltage needed to generate the desired gradient current, thereby allowing the amplifier to be correspondingly reduced in power output.

In one embodiment the DC power supplies may include large storage capacitors capable of receiving energy from the inductive gradient coils when the gradient field is reduced.

It is another object of the invention, therefore, to take advantage of the inductive, energy storing nature of the gradient coils. The peak power demanded of the gradient amplifiers is during periods when the gradient strength must be changed. In these periods, energy is added to or subtracted from the energy stored in the gradient coils. The use of capacitors in the output of the DC power supplies allows this stored energy to be recaptured from the gradient coils during periods when the gradient coil strength is being reduced and added again during periods when the gradient signal is being increased.

Not all energy may be successfully recaptured from the gradient coils by the storage capacitors. Therefore, they soon need supplemental recharging.

In a further embodiment, the storage capacitors my be recharged by the amplifier during the changing of the gradient level. A capacitor reference voltage is used to indicate a desired peak capacitor voltage corresponding to a first gradient current flow. A sample of the peak voltage on the capacitor is used to produce a peak voltage signal which together with the reference voltage generates an error signal. The error signal produces a current to add to the first and second currents in the gradient coil, to move the peak capacitor voltage toward the value of the reference voltage.

Thus it is yet another object of the invention to eliminate the need for supplemental recharging circuitry in the DC power supplies, but to use the amplifier itself for the purpose of making up the charge lost in the DC power supply capacitors.

Other objects and advantages besides those discussed above shall be apparent to those experienced in the art from the description of a preferred embodiment of the invention which follows. In the description, reference is made to the accompanying drawings, which form a part hereof, and which illustrate one example of the invention. Such example, however, is not exhaustive of the various alternative forms of the invention, and therefore reference is made to the claims which follow the description for determining the scope of the invention.

### Brief Description of the Drawings

Fig. 1 is a graphical representation of an MRI pulse sequence showing gradient field waveforms Gₓ, G_{y}, and G_{z};
Fig. 2 is a block diagram of an MRI apparatus incorporating the amplifiers of the present invention;
Fig. 3 is a simplified block diagram of one gradient amplifier of Fig. 2 showing the interconnections between amplifiers and DC power supplies;
Fig. 4 is a schematic diagram of a first embodiment of the DC power supplies of Fig. 3, showing the positioning of an energy storage capacitor bank;
Fig. 5 is a block diagram of a controller for switching the DC power supply of Fig. 4 in response to a gradient signal;
Fig. 6 is a block diagram of a capacitor voltage correction circuit used to control the amplifiers of Fig. 3 to recharge the capacitors of the DC power supply of Fig. 4;
Fig. 7(a) is a graph of a hypothetical gradient signal input to the gradient amplifier of Fig. 4;
Fig. 7(b) is a graph of the derivative of the gradient signal of Fig. 7(a) such as is used to control the DC power supply of Fig. 4;
Fig. 7(c) is a graph of the voltage on the capacitor bank of the DC power supply of Fig. 4 for the gradient signal of Fig. 7(a);
Fig. 7(d) is a graph of a current correction signal used to restore the charge of the capacitor bank of the DC power supply of Fig. 4 caused by resistive or other losses;
Fig. 7(e) is a graph of the gradient coil current produced by the gradient signal of Fig. 7(a) and the correction current of Fig. 7(d);
Fig. 8 is a schematic diagram of a second embodiment of the DC power supplies of Fig. 3, showing the use of multiple DC sources having binary weighted outputs; and
Fig. 9 is a block diagram of a controller for switching the DC power supply of Fig. 8 in response to a gradient signal.

### Detailed Description of the Preferred Embodiment

### MRI System Hardware

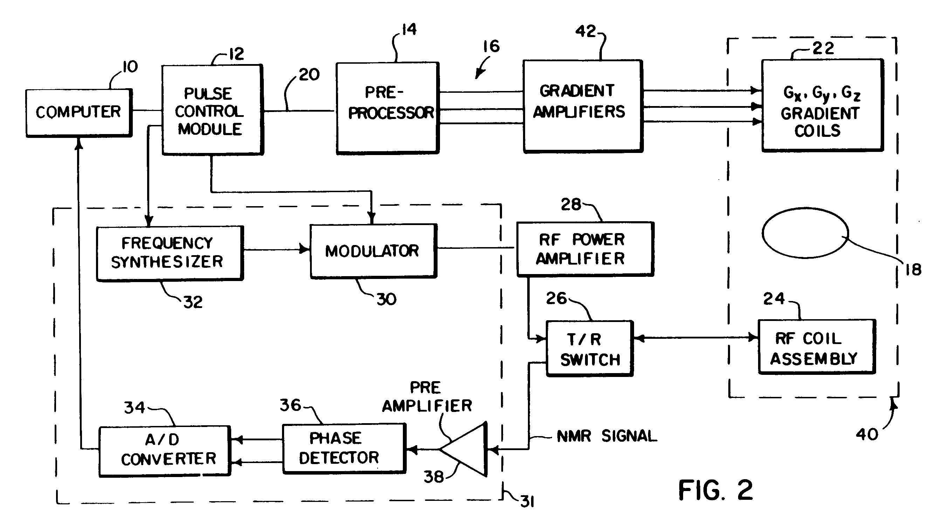

Referring to Fig. 2, the RP and gradient field signals used in MRI pulse sequences, such as that shown previously in Fig. 1 for spin warp imaging, are generated by a pulse control module 12 rich synthesizes properly timed pulse sequences under the control of a computer 10.

The pulse control module 12 communicates by means of a digital signal 20 to a gradient waveform preprocessor 14 which converts the digital signal 20 into three analog gradient signals 16, one for each gradient axis. The analog gradient signals 16 are communicated to a set of three identical gradient amplifier systems 42 each connected to a gradient coil 22 to produce the gradients Gₓ, G_{y}, and G_{z} as described above.

Each gradient coil 22 consists of a number of turns of a copper conductor and is arranged in proximity to a patient 18 in the magnet assembly 40. The magnet assembly 40 also contains the superconducting magnet for producing the polarizing field B₀ as is generally described in U.S. Patent 4,737,716 entitled: "Self-Shielded Gradient Coils For Nuclear Magnetic Resonance Imaging" issued August 12 1988, assigned to the same assignee as the present invention and incorporated herein by reference.

The pulse control module 12 also controls a radio frequency synthesizer 32, which is part of an RF transceiver system, portions of which are enclosed by block 31. The pulse control module 12 additionally controls an RF modulator 30 which modulates the output of the radio frequency synthesizer 32. The resultant RF signals, amplified by power amplifier 28 and applied to RF coil 24 through transmit/receive switch 26, are used to excite the nuclear spins of the imaged patient 18.

The NMR signals from the excited nuclei are picked up by the RF coil 24 in the magnet assembly 40 and presented to preamplifier 38 through transmit/receive switch 26, to be amplified and then processed by a quadrature phase detector 36. The detected signals are digitized by a high speed A/D converter 34 and applied to computer 10 for processing to produce images of the patient 18.

### Gradient amplifiers

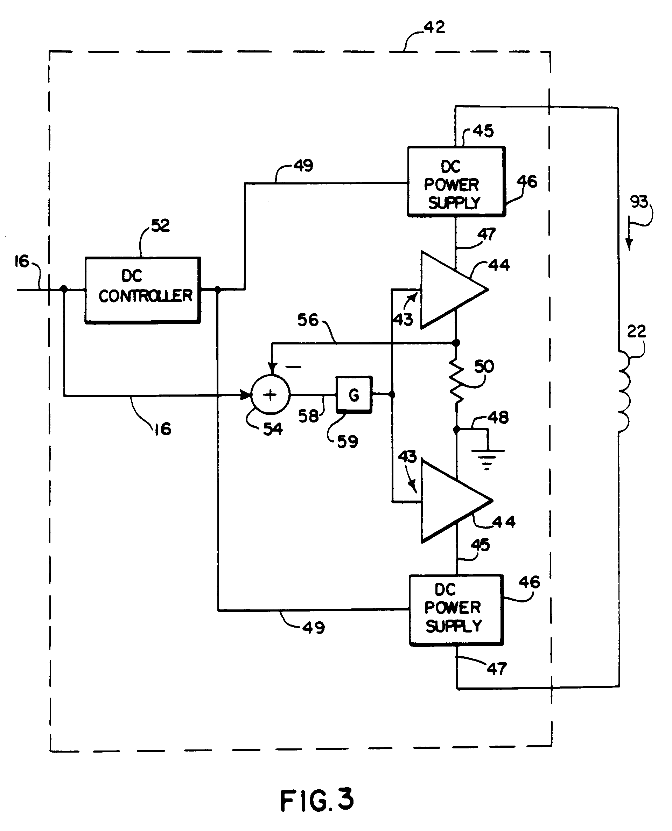

Referring now to Figs. 2 and 3, each gradient amplifier 42, associated with a particular gradient coil 22 of the three gradient axes Gₓ, G_{y} and G_{z}, includes a series connected chain of linear amplifiers 44 and DC power supplies 46. This series connected chain is, in turn, connected across a gradient coil 22 to provide power to that coil 22.

Each linear amplifier 44 provides a voltage output that is a simple multiplicative scaling of a signal at its input 43. Further, the output of the linear amplifier 44 is substantially continuous, that is, the output is not subject to movement in discrete steps but is controllable, by the signals at its input 43, to an arbitrary value within the output range of the linear amplifier 44.

Each linear amplifier 44 is designed in bridge configuration to have a "floating output". That is, it produces an output voltage defined with respect to two terminals neither of which is referenced to a ground that is common with the other circuit elements of the gradient amplifier 42. The floating output allows the voltage output of the linear amplifier 44 to be added to other voltage sources simply by connecting it in series with such other sources. Linear amplifiers 42 are known in the art and are described in U.S. patent 3,808,545 entitled: "High Power Bridge Audio Amplifier" and incorporated herein by reference.

The DC power supplies 46, as will be described in more detail below, provide only discrete steps of output voltage and thus may be contrasted to the linear amplifiers 44 by the fact that their outputs are not a continuous function of an input value. In a simplest embodiment, the DC power supplies 46 are capable of only three voltage outputs: zero volts and a predetermined voltage of either of two polarities.

Like the linear amplifiers 44, the DC power supplies 46 have floating outputs producing voltages defined between first and second output terminal 45 and 47 respectively. The DC power supplies 46 do not have inputs, in the sense of the linear amplifiers 44, but receive an activation and polarity signal which determines the polarity of the output voltage produced across the terminals 45 and 47 of the DC power supply 46, or, in one embodiment to be described below, selects from one of several discrete output voltage values.

As mentioned, the linear amplifiers 44 and the DC power supplies 46 are connected in series across the gradient coil 22. The linear amplifiers 44 and DC power supplies 46 are also paired symmetrically about a ground point 48 so as to drive the gradient coil 22 symmetrically about that ground point 48. This arrangement serves to minimize the voltage swing between any part of the gradient coil 22 and the ground 48, during the driving of the gradient coil 22, and thus reduces the effects of capacitive coupling between the gradient coil 22 and objects such as the patient 18 which may be at fixed voltage with respect to the ground 48. Each DC power supply 46 and linear amplifier 44 receives the same input 43 or activation and polarity signal to provide this symmetry.

A current sensing feedback resistor 50 is inserted in series between one linear amplifier 44 and the ground point 48 to provide a voltage drop indicative of the current flow through the series connected DC power supplies 46, linear amplifiers 44 and gradient coil 22. The value of the feedback resistor 50 is sufficiently low so as not to substantially effect the symmetrical application of voltage to the gradient coil 22 as described above. The purpose of the feedback resistor 50 is to provide an indication of the actual gradient field produced. As such, it will be understood to those of ordinary skill in the art that other feedback signals may be used including those from Hall effect transducers or DC transformers.

The series connection of the DC power supplies 46 and the linear amplifiers 44, as described above, combines the advantages of each power source. The linear amplifiers 44 provide accurate and continuous regulation of the current through the gradient coil 22, particularly needed during the periods of collection of the NMR data, while the DC power supplies provide a relatively inexpensive and reliable source of high voltage necessary to rapidly switch the gradient currents against the inductive load of the gradient coil 22. The linear amplifiers 44 serve to "fill-in" for voltage values between those provided by the DC power supplies 46 and to effectively regulate the combined voltage as will be described below.

The coordination of the DC power supplies 46 and the linear amplifiers 44 is provided by the combined action of an open-loop DC controller 52 and closed-loop current feedback employing summing node 54. The analog gradient signal 16, reflecting the desired current through gradient coil 22 is received both by the DC controller 52 and the summing node 54. As will be described in more detail below, based on the gradient signal 16, the DC controller 52 controls the polarity and discrete voltage of the DC power supplies 46 to provide an approximation of the necessary voltage needed to drive the required current through gradient coil 22.

A current feedback signal 56 derived from the current sensing resistor feedback 50 is subtracted from the same gradient signal 16 to derive an error signal 58 according to conventional feedback control. This error signal 58 represents the difference between the current through the gradient coils 22 and the desired current as indicated by the gradient signal 16. This error signal 58, after passing through gain block 59, is input to the linear amplifiers 44. The gain block provides the necessary signal amplification and compensation to satisfy amplifier stability criteria such as are understood in the art. The linear amplifiers 44 provide a voltage output supplementing that of the DC power supplies 46 and modifying the current flow through the gradient coil 22 to reduce the error signal 58 to zero. The error signal 58 thus brings the current through the gradient coil 22 to the desired value reflected in the gradient signal 16.

Thus, the DC power supplies 46 are controlled directly by the gradient signal 16 without regard to the actual current flowing through the gradient coil 22, and the linear amplifiers 44 are controlled by the actual current flowing through the gradient coils 22 to make up whatever difference is required to bring that current to the proper level. The linear amplifiers 44 sense the gradient coil current through feedback resistor 50.

In order that the two sources of gradient power, the DC power supplies 46 and the amplifiers 44, operate effectively together, the unit of voltage which my be applied to the gradient coil 22 by each DC power supply 46 is limited to a value less than the maximum output voltage of the linear amplifier 44. This ensures that the combination of the linear amplifiers 44 and the DC power supplies 46 can provide a continuously varying controlled voltage anywhere within a range from zero volts to a maximum equal to the sum of the maximum output voltages of the linear amplifiers 44 and DC power supplies 46.

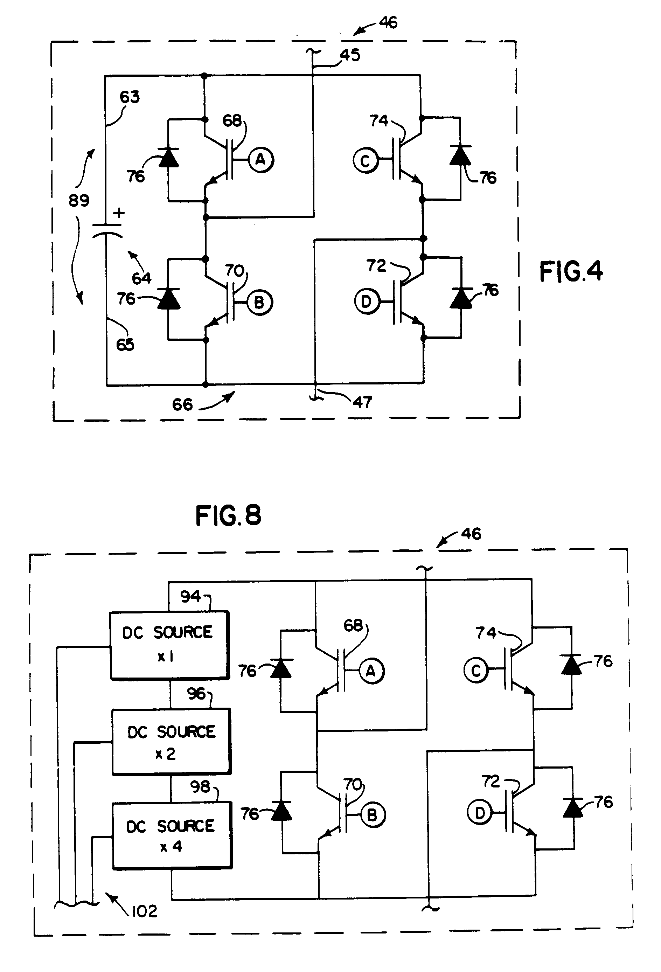

Referring now to Figs. 3 and 4, in a first embodiment, each DC power supply 46 includes a capacitor bank 64 which is precharged to a capacitor standby voltage by a low powered charger (not shown) measured between a positive terminal 63 and negative terminal 65. This capacitor bank 64 is connected, through a switching network 66 to the first and second terminals 45 and 47 of the DC power supply 46.

The switching network 66 includes four N-channel IGBT type power transistors 68 through 74 which are arranged to connect the capacitor bank 64 in series with the gradient coil 22 in either of two polarities, i.e. so that the first terminal 45 of the DC power supply 46 is either: 1) more positive than the second terminal 47 (the "positive polarity") or 2) more negative than the second terminal (the "negative polarity"). The transistors 68 to 72 of the switching network 66 may also be controlled to as to disconnect the capacitor bank 64 from the gradient coil 22 and to connect together the first and second terminals 45 and 47 of the DC power supply 46, producing zero output voltage (the "shorted" state).

Specifically, transistors 68 and 70 are connected across the capacitor bank 64, with the collector of transistor 68 connected to the positive terminal 63 of the capacitor bank 64 and its emitter connected to the collector of transistor 70 and to the first terminal 45 of the DC power supply output 46. The emitter of transistor 70 is then connected to the negative terminal 65 of the capacitor bank 64. Likewise transistors 74 and 72 are also connected in series across the capacitor bank 64, with the collector of transistor of 74 connected to the more positive terminal 63 of the capacitor bank 64 and its emitter connected to the second terminal 47 of the DC power supply 46 and to the collector of transistor 72. The emitter of transistor 72 is in turn connected to the negative terminal 65 of the capacitor bank 64.

Each of transistors 68 through 74 has a diode 76 arranged to conduct current from the emitter of each transistor 68 through 74 to its collector. It will be understood from this description that these diodes 76 thus form a full wave rectifier bridge, each leg of the bridge having one transistor 68 through 74 bridging that leg.

The base of each transistor 68 through 74 may be biased "on" or "off" to produce the negative polarity, positive polarity and shorted states described above. This biasing is shown in Table I where the letters A through D identify the bases of transistors 68 through 72 respectively.

**TABLE I**

| **STATE** | **A** | **B** | **C** | **D** |
|---|---|---|---|---|
| negative polarity | off | on | on | off |
| positive polarity | on | off | off | on |
| shorted (1) | off | on | off | on |
| shorted (2) | on | off | on | off |
| off | off | off | off | off |

Thus, the switching network 66 allows the voltage of the capacitor bank 64 to be selectively applied to the gradient coil 22 to augment the voltage produced by the linear amplifiers 44. The transistors 68 through 74 operating largely either in a fully on or fully off state, consume little power (as opposed to the transistors of the linear amplifiers 44) and hence preserve the natural efficiency of the DC power supplies 46 in delivering power to the gradient coil 22.

Referring now to Figs. 3, 4 and 5, the DC power supplies 46 of Fig. 4 are controlled by a DC controller 52 which produces the activation and polarity signals 49 made up of base driving signals for transistors 68 through 74as detailed in Table I.

The DC controller 52 employs a differentiator 78, which receives the analog gradient signal 16 (indicating the desired current through gradient coil 22) and takes its derivative with respect to time. This derivative is multiplied by the impedance of the gradient coil 22 to produce an accelerating voltage value 80 representing the voltage that would have to be applied to the gradient coil 22 to achieve the change in current through the gradient coil 22 dictated by the gradient signal 16. It will be understood that although the gradient coil 22 is modeled above as a simple inductance, that more complex models may readily be employed, such models including resistive and capacitive effects, the frequency dependance of the impedance, and capacitive and inductive coupling between the gradient coil 22 and the patient and magnet structure.

This accelerating voltage 80 is received by a two-step comparator 82 which produces a positive polarity signal 84 if voltage 80 is greater than or equal to the total precharged voltage of capacitor bank 64 times the number of DC power supplies 46. The two step comparator produces a negative polarity signal 86 if voltage value 80 is less than or equal to the negative of the total precharged voltage of capacitor bank 64 times the number of DC power supplies 46. For other voltages 80, the two step comparator 82 produces neither signal 84 or 86 which indicates a shorted condition of the DC power supply 46 is desired.

Switch logic 83 next interprets the positive and negative polarity signals 84 and 86 into base driving signals for transistors 68 through 70, of the switching networks 66, according to Table I. These base driving signals are the activation and polarity signals 49.

Thus, if the required voltage across the gradient coil 22 is at least as great as the precharge voltage which is provided (initially) by the DC power supplies 46, the DC power supplies 46 are connected to the gradient coil 22. Incremental voltages greater or less than the precharged voltage of the capacitor bank are provided by the linear amplifiers 44.

The capacitor bank 64 may both source and sink current to and from the gradient coil 22 so that at the conclusions of a gradient excitation, i.e., when the current through the gradient coil 22 is zero, the precharge voltage on the capacitor bank 64 is largely undiminished. The condition that the precharge voltage is undiminished strictly requires that the magnitude of the slope of the change in the gradient current be constant for changes in the gradient field. Even under these conditions, some diminution of charge occurs, however, because of the resistive component of the gradient coil 22 and other loss elements. Accordingly, the charge on the capacitor bank 64 must be augmented by some recharging of the capacitor bank 64 from an external source. This external source may be a separate power supply, however, preferably, and if the DC power supply 46 is sufficient alone to provide the change in gradient current, the linear amplifiers 44 are used. Restoration of the charge on capacitor bank 64, permits the assumption of a constant precharge voltage implicit in the calculation performed by the two step comparator 82 in deciding whether to switch the DC power supplies 46 into the circuit or not.

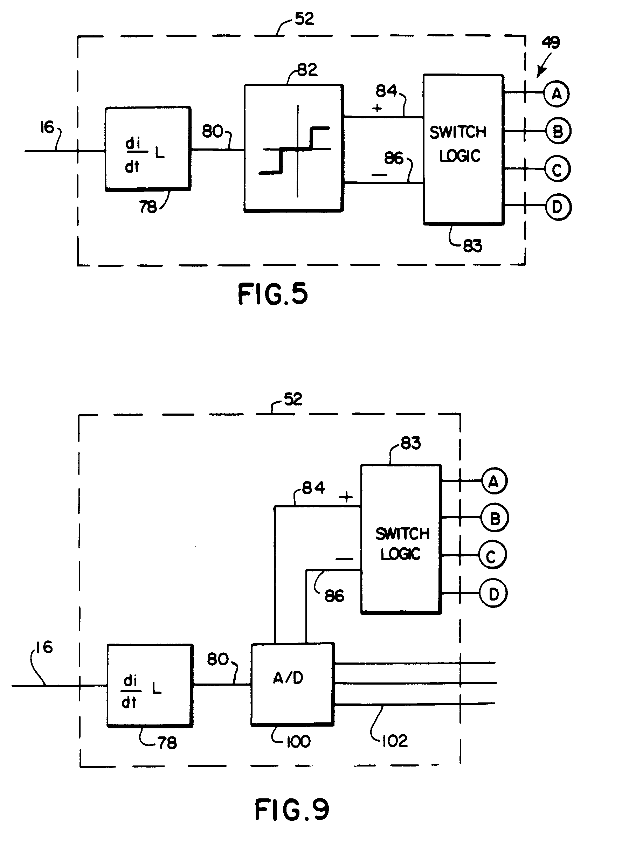

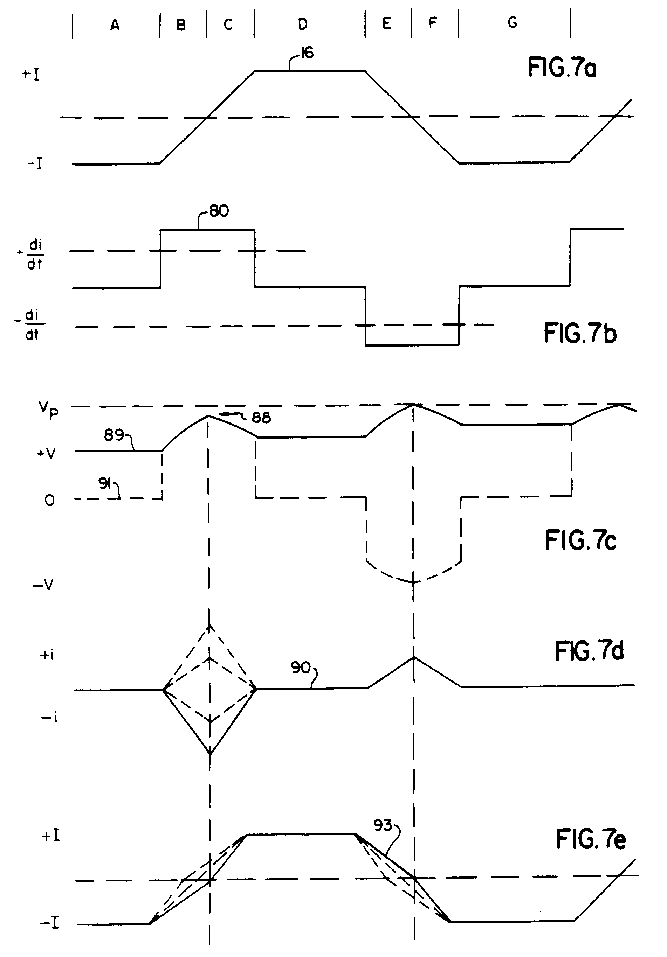

Referring to Fig. 7(a) a gradient signal 16 may be divided into periods of constant gradient strength (hence constant current) **A**, **D**, and **G** and periods of transition or changing gradient strength **B/C**, and **E/F**. The derivative of the gradient signal 16, as produced by the differentiator 78 of Fig. 5, produces a voltage signal 80, shown in Fig. 7(b). The voltage signal 80 is related to the gradient signals 16, by having a value of zero for the constant periods **A**, **D**, and **G** and a finite magnitude for the transition periods **B/C**, and **E/F**. If the value of the voltage 80 during transition periods **B/C**, and **E/F** is sufficient, the DC controller 52 will connect the capacitor bank 64 to the gradient coil 22.

Referring to Fig. 7(c), the voltage 89 on the capacitor bank 64, when it is connected to the gradient coil 22 at the start of a transition in periods **B** or **E**, rises toward the capacitor precharge voltage Vₚ as the capacitor bank 64 is connected to oppose the voltage of the gradient coil 22 and receives current from the gradient coil 22. The voltage 89 on the capacitor bank 64 then peaks at voltage 88 as the current through the gradient coil 22 reaches zero (the energy of the gradient coil having been effectively transferred to the capacitor bank 64) and then begins to fall again as the current through the gradient coil 22 reverses direction and charge is drained from the capacitor bank 64 in periods **C** and **F**. The DC power supply 46 is then shunted so that the output voltage 91 drops to zero, however the voltage 89 on the capacitor bank 64 simply remains constant at a standby level. The difference in voltage between the capacitor precharge value Vₚ and the peak voltage 88, when gradient current is zero, represents the loss of charge in the capacitor bank 64 due to resistance of the gradient coil 22 and other loss mechanisms. This loss may be corrected, provided the voltage of the DC power supply is sufficient to handle the changes in gradient filed, by the linear amplifiers 44 by providing them with a correction signal 90, shown in Fig. 7(d) during the transition periods **B/C**, and **E/F**.

The correction signal 90 is summed to the error current 58 prior to it being received by the inputs 43 of the linear amplifiers 44 so that the voltage 89 on the capacitor bank 64 rises faster or slower during period **B** or **E** than it falls during periods **C** or **F**.

Specifically, the correction signal 90 comprises a triangle wave having a varying amplitude dependent on the difference between the precharge voltage Vₚ and the peak voltage 88 during the most recent transition between periods **B** and **C**, or **E** and **F**.

Referring to Fig 7(d) and (e), the correction signal 90, when summed with the error signal 58 alters actual gradient current 93 during the transition periods **B/C**, and **E/F** slightly, modifying the gradient current 93 from that dictated by the gradient signal 16. Nevertheless, it has been determined that this slight modification of the gradient waveform during transition periods **B/C** and **E/F** is acceptable in its effect on the fidelity of the produced NMR image and of no effect for many imaging techniques where NMR data is only taken during periods of constant gradient value **A**, **D** and **G**.

Referring again to Fig. 7(c), as the peak voltage 88 approaches the desired precharge voltage Vₚ of the capacitor bank 64, the triangle wave of the correction signal 90 decreases in amplitude so that the capacitor peak voltage 88 asymptotically approaches the desired precharge voltage Vₚ.

The capacitor precharge voltage Vₚ, as mentioned, affects the proper switching point of the DC power supplies 46 into the circuit as controlled by the two step comparator 82. Nevertheless, the inherent correction action of the feedback loop of linear amplifiers 44 reduces the importance of precisely regulating the capacitor peak voltage to equal the desired precharge voltage Vₚ.

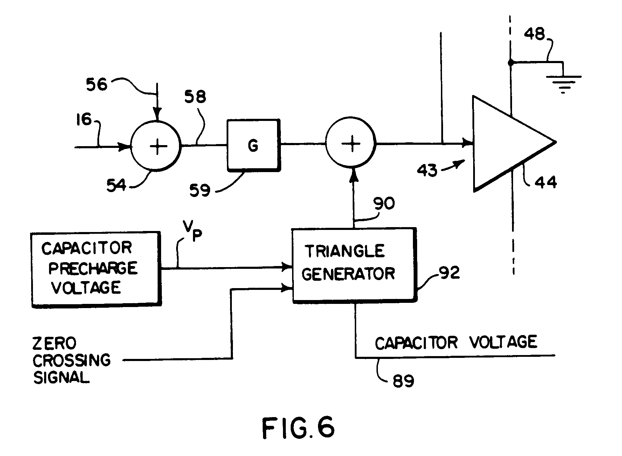

Referring to Fig. 6, the correction signal 90 is produced by a triangle generator 92 generating the above described triangular waveform during transition periods **B/C**, and **E/F**. The capacitor peak voltage 89 is sampled during the transition times of the gradient current 93 and compared to a reference supply 99 indicating the desired level of the capacitor precharge voltage Vₚ The zero crossing signal 97 also provides polarity information to the triangle generator 99 to produce the proper polarity of triangle wave to correspond to the gradient signal 16 as shown in Fig. 7(a) and (d).

The correction signal 90 produced by the triangle generator 92 is summed to the error signal 58 and the sum provided to the inputs 43 of the linear amplifiers 44.

Referring now to Fig. 8, in a second embodiment, the capacitor bank 64 is replaced with series connected DC sources 94 through 98 together to provide a voltage across terminals 63 and 64, where terminal 63 is the more positive terminal of the two. Each DC source 94 through 98 provides either a positive voltage weighted according to a binary weighting scheme or a shorted state of zero voltage. In the shorted state, the DC voltages 94 through 98 present a zero resistance across their terminals to transmit the voltage of the other series connected sources. Thus, combinations of the DC sources 94 through 98 either at their positive voltage values or shorted may produce a range of equally stepped voltages from zero to the sum of their positive voltages. The DC sources 94 through 98 are conventional "four quadrant" floating power supplies having transistors which disconnect their outputs from power and short those output when they are in the shorted state.

The weighting of the DC sources 94 through 98 is such that the voltage of DC source 96 is twice that of DC source 94 and the voltage of DC source 98 is four times that of the DC source 94. The DC power supply 46 may thus produce not one but eight equally spaced discrete voltage levels and, by means of switching network 66, two polarities. Nevertheless, the DC power supply 46 using the DC sources 94 through 98 still produce a discontinuous output which must be corrected to conform to the precise gradient signal 16 by the linear amplifiers 44.

Referring to Fig. 9, the control of the DC sources 94 through 98 of Fig. 8 is accomplished by a modified DC controller 52 receiving the analog gradient signal 16. The gradient signal 16 is again differentiated by differentiator 78 and multiplied by the inductance of the gradient coil 22 to produce an accelerating voltage value 80.

The voltage value 80, which is equal to the voltage that must be applied across the gradient coil 22 to achieve the desired gradient current, is received by a three bit analog-to-digital converter 100. The analog-to-digital converter 100 converts the voltage value 80 into a three bit digital word 102, one bit of which controls each of the DC sources 94 through 98. Specifically, one bit of the three bit word 102 is connected to one of the three DC sources 94 through 98 with the most significant bit of the three bit word 102 controlling DC source 98. Each DC source 94 through 98 provides a shunted zero volt output when corresponding bit of word 102 is in the "false" state and a positive voltage output when the corresponding bit of word 102 is in the "true" state.

The analog-to-digital converter 100 also produces polarity signals 84 and 85 to control the switching network 66, and indicating whether the voltage value 80 is greater than or less than zero, volts. Such polarity signals driving switch logic 83, as before, to control the switching network 66 of the DC power supply 46.

The above description has been that of a preferred embodiment of the present invention. It will occur to those who practice the art that many modifications may be made without departing from the spirit and scope of the invention. For example, it will be understood from the above discussion that the symmetrical driving of the gradient coil 22 is not essential to the invention but that non-symmetrical configurations may be employed. In such non-symmetrical configuration, a single linear amplifier and DC power supply may be used. Or, multiple power supplies and amplifiers may be used and controlled with different signals to produce a non-symmetrical driving of the gradient coil. Further, the DC sources 94 through 98 may each include separate capacitor banks 64 so as to both generate and receive gradient current. In order to apprise the public of the various embodiments that may fall within the scope of the invention, the following claims are made.

## Claims

1. A gradient amplifier for a gradient coil of a magnetic resonance imaging system, the amplifier receiving a gradient signal and producing voltage to generate a gradient current in a gradient coil to produce a desired magnetic gradient field, the amplifier comprising:
a DC power supply having an input for receiving the gradient signal and having an output connected to the gradient coil for impressing a first voltage component across the gradient coil, selectable from a discontinuous range of output voltages, approximating the voltage needed to produce the gradient current;
a feedback sensor connected to the gradient coil for producing a feedback signal indicative of a magnetic gradient field produced by the gradient coil; and
an amplifier having an output connected to the gradient coil for impressing a second voltage component across the gradient coil, a second voltage component being within a continuous range of output voltages, and having an input receiving the feedback signal and the gradient signal to adjust the second voltage component so that the sum of the first and second voltage components generates the gradient current in the gradient coil to produce the desired magnetic gradient field.

2. The gradient amplifier as recited in claim 1 wherein the DC power supply is more than one DC source, each such DC source switchable to produce an incremental voltage or zero voltage, the DC sources connected so that the sum of the incremental voltages define the discontinuous range of output voltages and so that the first voltage component, output from the DC power supply, is the sum of only the incremental voltages from those DC sources that are switched to produce an incremental voltage.

3. The gradient amplifier as recited in claim 2 wherein the incremental voltages for each DC source differ in value between each DC source in according to a binary relationship.

4. The gradient amplifier as recited in claim 1 wherein the feedback sensor is a resistor connected in series with the gradient coil to generate a voltage proportional to the gradient current and hence the gradient magnetic field.

5. The gradient amplifier as recited in claim 1 wherein the DC power supply is a precharged capacitor which may be connected to or disconnected from the gradient coil to generate either a first voltage component or zero voltage.

6. The gradient amplifier as recited in claim 1 including:
a capacitor reference voltage indicating a desired peak capacitor voltage corresponding to a first current flow sample means for determining the voltage on the capacitor to produce a voltage signal; and
an error voltage generator having an input for receiving the reference voltage and the voltage signal for producing a third voltage component to add to the first and second voltage components across the gradient coil to move the peak capacitor voltage toward the value of the reference voltage.

7. The gradient amplifier as recited in claim 7 wherein the error voltage generator is gated to produce the third voltage component only during changes in the gradient current caused by changes in the first or second voltage components.

8. A gradient amplifier for a gradient coil of a magnetic resonance imaging system, the amplifier receiving a gradient current signal and producing a corresponding gradient current in a gradient coil having an impedance L to produce a desired magnetic gradient field, the amplifier comprising:
a differentiator for differentiating the gradient current signal to produce a driving voltage signal;
a DC power supply having an output connected to the gradient coil for impressing a first voltage component across the gradient coil selectable from a discontinuous range of output voltages;
a digitizer for receiving the driving voltage signal and connected to the DC power supply for producing a digital switching signal to select the first voltage component from the discontinuous range of output voltages to approximate the voltage needed to generate the gradient current;
a feedback sensor connected to the gradient coil for producing a feedback signal indicative of the gradient current; and
an amplifier having an output connected to the gradient coil for impressing a second voltage component across the gradient coil, a second voltage component being within a continuous range of output voltages, and having an input receiving the feedback signal and the gradient signal to adjust the second voltage component so that the sum of the first and second voltage components generates the gradient current in the gradient coil to produce the desired magnetic gradient field.
